# EUROPÄISCHE PATENTANMELDUNG

(11) **EP 2 365 561 A2**
(43) Veröffentlichungstag der Anmeldung: **14.09.2011**
(21) Anmeldenummer: 10015478.0
(22) Anmeldetag: 09.12.2010
(51) Int. Cl.: H01M 2/20, H01R 11/28

(54) **Busbarplatte mit federnd angebundenen Stromschienen**

(30) Priorität: 09.03.2010 DE 102010010815
(71) Anmelder: Carl Freudenberg KG, 69469 Weinheim (DE)
(72) Erfinder: Zischka, Helmut, 71287 Weissach (DE)

(57) **Zusammenfassung**

Eine Busbarplatte (1) für eine Batterie mit einzelnen Zellen, umfassend eine Grundplatte (2) und Stromschienen (3) zur Kontaktierung von Polanschlüssen der Zellen, wobei auf der Grundplatte (2) Leiterbahnen (4) verlaufen, die über Kontaktelemente (5) mit den Stromschienen (3) elektrisch leitend verbunden sind, ist im Hinblick auf die Aufgabe, eine betriebstaugliche Busbarplatte anzugeben, welche eine mechanisch stabile und zuverlässige Kontaktierung der Zellen einer Batterie erlaubt, dadurch gekennzeichnet, dass die Kontaktelemente (5) an den Stromschienen (3) relativ zur Grundplatte (2) flexibel beweglich angebunden sind.

## Beschreibung

### Technisches Gebiet

Die Erfindung betrifft eine Busbarplatte für eine Batterie mit einzelnen Zellen, umfassend eine Grundplatte und Stromschienen zur Kontaktierung von Polanschlüssen der Zellen, wobei auf der Grundplatte Leiterbahnen verlaufen, die über Kontaktelemente mit den Stromschienen elektrisch leitend verbunden sind.

### Stand der Technik

Batterien bzw. elektrochemische Energiespeicher für Elektro- bzw. Hybridfahrzeuge bestehen typischerweise aus mehreren hundert einzelnen Zellen, die in einem Batteriegehäuse platziert sind. Hierbei ist eine Unterteilung in Module möglich. Gängige Batterietechnologien umfassen Nickel-Metallhydrid- bzw. Lithium-basierte Systeme. Daneben kommen Superkondensatoren zum Einsatz.

Die einzelnen Zellen weisen Polanschlüsse auf, die mit Stromschienen, den sogenannten Busbars, verbunden werden, um eine Reihenschaltung herzustellen. Zur Herstellung der Reihenschaltung werden Polanschlüsse je zweier Zellen miteinander verbunden.

Vor diesem Hintergrund hat eine Busbarplatte mehrere Aufgaben. Sie soll die Kontaktierung der Leistungselektronik der Zellen herstellen, wobei Spannungen U bis ca. 300 V und Ströme I bis 500 A auftreten. Sobald einer der Kontakte der Leistungselektronik ausfällt, kann die komplette Batterie unbrauchbar werden. Insbesondere ein Elektroauto würde dann stehen bleiben. Aufgrund der hohen Spannungen und Energiegehalte kann eine Schädigung der Kontakte häufig nicht rasch behoben werden.

Die Busbarplatte soll auch die Kontaktierung einer Oberwachungselektronik, welche die einzelnen Zellen im Hinblick auf Lade- und Entladeströme, Ladezustand und Temperatur überwacht, herstellen. Diese Überwachung ist notwendig, um eine Leistungsfähigkeit der Batterie während deren gesamter Lebensdauer zu garantieren. Diese Leistungsfähigkeit hängt von der schwächsten Zelle ab. Insbesondere bei Lithium-basierten Zellen ist ein Ausfall einzelner Zellen besonders kritisch, da solche Zellen, insbesondere bei Überladung mit starken Strömen, Ursache von Bränden und/ oder Explosionen sein können. Fällt die Oberwachungselektronik aus, wird die Batterie aus sicherheitstechnischen Gründen abgeschaltet.

Alle Kontaktierungen müssen automobiltauglich sein, insbesondere die Norm TS 16949 erfüllen. Sie müssen sicher gegen Vibrationen sein, Temperaturschwankungen beschädigungsfrei aushalten und mechanischen Verschiebungen durch Volumenarbeit bei flexiblen Zellen Stand halten. Zellen mit flexiblen Hüllen, sogenannte Rundzellen oder prismatische Zellen, dehnen sich beim Laden aus. Typisch sind hier Dickenänderungen zwischen ge- und entladenem Zustand von ca. 5 %.

Derzeit existieren Busbarplatten mit einer glasfaserverstärkten Grundplatte, auf der Leiterbahnen fixiert sind. Solche Busbarplatten sind als FR4-Leiterplatten bekannt. Die Starre der Grundplatte führt in nachteiliger Weise zu einer Kraftbeaufschlagung durchgalvanisierter Hülsen, die mit den Polanschlüssen in Verbindung stehen. Bei einer Verschiebung zweier oder mehrerer Polanschlüsse relativ zueinander können die Grundplatte, die Leiterbahnen oder die Kontaktelemente, welche die Leiterbahnen mit den Stromschienen verbinden, reissen oder brechen.

### Darstellung der Erfindung

Der Erfindung liegt daher die Aufgabe zugrunde, eine betriebstaugliche Busbarplatte anzugeben, welche eine mechanisch stabile und zuverlässige Kontaktierung der Zellen einer Batterie erlaubt.

Die vorliegende Erfindung löst die zuvor genannte Aufgabe durch eine Busbarplatte mit den Merkmalen des Patentanspruchs 1.

Danach ist die eingangs genannte Busbarplatte bzw. Stromschienenplatte dadurch gekennzeichnet, dass die Kontaktelemente an den Stromschienen relativ zur Grundplatte flexibel beweglich angebunden sind.

Erfindungsgemäß ist erkannt worden, dass hierdurch ein Reissen oder Brechen der Leiterbahnen und der Kontaktelemente verhindert werden kann, wenn die Stromschienen bzw. die Polanschlüsse oder Zellen bewegt werden. Konkret ist erkannt worden, dass ein flexibel beweglich angebundenes Kontaktelement einen Toleranzausgleich in drei Dimensionen ermöglicht. Insoweit ist eine betriebstaugliche Busbarplatte angegeben, welche eine mechanisch stabile und zuverlässige Kontaktierung der Zellen einer Batterie erlaubt.

Folglich ist die eingangs genannte Aufgabe gelöst.

Vor diesem Hintergrund könnten die Stromschienen flexibel beweglich an der Grundplatte angebunden sein. Sie Stromschienen selbst können gemeinsam mit den an ihnen angebundenen Kontaktelementen geringen Bewegungen der Polanschlüsse der Zellen relativ zur Grundplatte folgen, ohne die Polanschlüsse oder Zellen mit mechanischer Spannung zu beaufschlagen. Hierdurch wird vermieden, dass Polanschlüsse von den Zellen abreissen oder dass in den Zellwandungen Risse entstehen. Des Weiteren ist eine mechanische Entlastung der Kontaktelemente und der Leiterbahnen möglich.

Die Stromschienen könnten federnd und/ oder elastisch beweglich an der Grundplatte angebunden sein. Hierdurch ist eine reversible Bewegung der Stromschienen in drei Dimensionen möglich. Des Weiteren ist eine mechanische Entlastung der Kontaktelemente und der Leiterbahnen möglich.

Die Stromschienen könnten durch Federelemente an der Grundplatte angebunden sein. Vorzugsweise ist eine Stromschiene mit vier Federelementen an der Grundplatte angelenkt. Mechanische Federelemente, insbesondere Spiralfedern oder Blattfedern, sind äußerst stabil und dauerhaft haltbar. Vorzugsweise werden Federelemente aus Kunststoff verwendet.

Die Stromschienen könnten durch ein Elastomer an der Grundplatte angebunden sein. Hierdurch können die Stromschienen durch Anspritzen oder Umspritzen in einfacher Weise an die Grundplatte angebunden werden. Vor diesem Hintergrund ist konkret denkbar, als Elastomere Ethylen-Propylen-DienKautschuk (EPDM) oder Silikon zu verwenden.

Die Stromschienen könnten durch einen Schaum an der Grundplatte angebunden sein. Vor diesem Hintergrund ist denkbar, Polyurethan zu verwenden. Schäume sind leicht und mechanisch belastbar.

Die Grundplatte könnte Ausnehmungen aufweisen, in denen die Stromschienen aufgenommen sind. Hierdurch können die Stromschienen mit den Oberflächen der Grundplatte fluchten. Vorteilhaft ragen die Stromschienen nicht über die Berandungen der Grundplatte hinaus.

Die Stromschienen könnten in den Ausnehmungen aufgenommen sein und von den Rändern der Ausnehmungen beabstandet sein. Hierdurch können die Stromschienen mit einem Freiweg ausgestattet werden, den sie relativ zur Grundplatte zurücklegen können, bevor sie an dieser anstossen.

Die Stromschienen könnten in Rahmen eingefasst sein. Die Federelemente die Rahmen und die Grundplatte können hierdurch materialeinheitlich und einstückig ausgebildet werden. Die Federelemente, die Rahmen und die Grundplatte können spritzgusstechnisch an die Stromschienen angeformt werden.

Die Grundplatte könnte als Kunststoffplatte ausgestaltet sein. Vorteilhaft weist die Busbarplatte hierbei ein sehr geringes Gewicht auf. Die Grundplatte könnte aus Polyamid bestehen. Polyamid ist sehr schlagzäh und dauerhaft stabil. Denkbar ist auch, dass die Grundplatte aus POM (Polyoxymethylen) besteht. Dieser Kunststoff ist sehr kostengünstig.

Die Stromschienen und eine auf der Grundplatte aufliegende Lage könnten durch die Kontaktelemente miteinander In elektrischem Kontakt stehen. Hierdurch ist eine Überwachung der Zellen einer Batterie durch eine Überwachungselektronik ermöglicht.

Die Stromschienen könnten mit der Lage durch Kontaktelemente mechanisch verbunden sein, die als Federkontakte, Crimpverbindungen, Clinchverbindungen, Schweissverbindungen, Lötverbindungen und oder Nietverbindungen ausgestaltet sind.

Die Lage könnte als flexibler Flachleiter mit Leiterbahnen ausgestaltet sein. Ein flexibler Flachleiter oder eine Folie kann mit Leiterbahnen bedruckt oder geätzt werden und problemlos auf die Grundplatte aufgeklebt werden. Vor diesem Hintergrund ist denkbar, dass die Lage als sogenannter "Flexible Printed Circuit" (FPC) ausgestaltet ist. Denkbar ist auch, die Lage durch Stifte mit der Grundplatte zu verbinden.

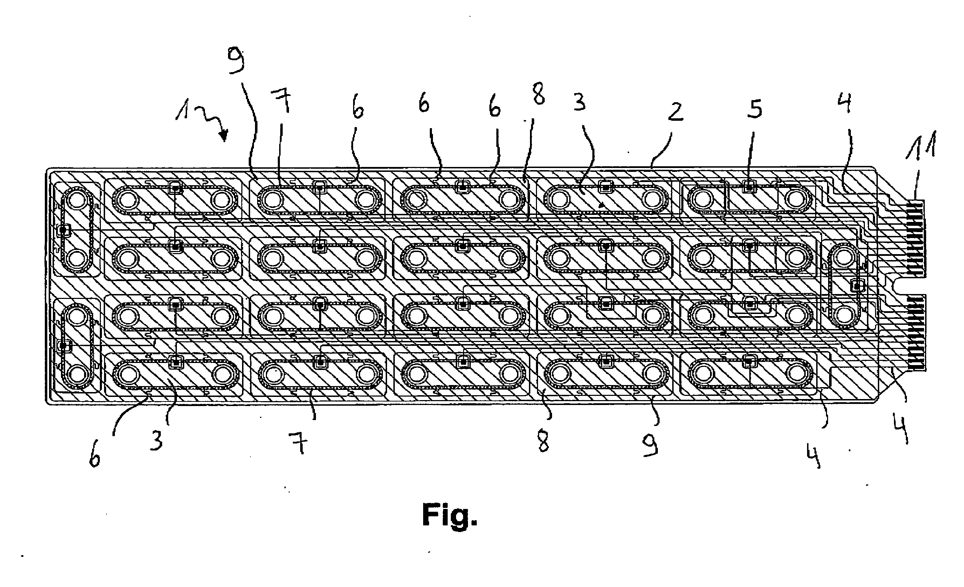

Es gibt nun verschiedene Möglichkeiten, die Lehre der vorliegenden Erfindung in vorteilhafter Weise auszugestalten und weiter zu bilden. Dazu ist einerseits auf die nachgeordneten Ansprüche, andererseits auf die nachfolgende Erläuterung eines bevorzugten Ausführungsbeispiels der erfindungsgemäßen Busbarplatte anhand der Zeichnung zu verweisen.

In Verbindung mit der Erläuterung des bevorzugten Ausführungsbeispiels anhand der Zeichnung, werden auch im Allgemeinen bevorzugte Ausgestaltungen und Weiterbildungen der Lehre erläutert.

### Kurzbeschreibung der Zeichnung

In der Zeichnung zeigt die einzige
- Fig.: eine Draufsicht auf eine Busbarplatte mit federnd angebundenen Stromschienen, auf der eine Lage mit Leiterbahnen aufliegt.

### Ausführung der Erfindung

Die einzige Fig. zeigt eine Busbarplatte 1 für eine Batterie mit einzelnen Zellen, umfassend eine Grundplatte 2 und Stromschienen 3 zur Kontaktierung von Polanschlüssen der Zellen, wobei auf der Grundplatte 2 Leiterbahnen 4 verlaufen, die über Kontaktelemente 5 mit den Stromschienen 3 elektrisch leitend verbunden sind. Die Kontaktelemente 5 sind an den Stromschienen 3 relativ zur Grundplatte 2 flexibel beweglich angebunden. Die Kontaktelemente 5 sind als Crimpkontakte und/ oder als Schweisspunkte ausgestaltet

Die Stromschienen 3 sind flexibel beweglich an der Grundplatte 2 angebunden, wobei die Stromschienen 3 federnd und/ oder elastisch beweglich an der Grundplatte 2 angebunden sind. Die Stromschienen 3 sind relativ zur Grundplatte 2 beweglich. Die Stromschienen 3 sind durch Federelemente 6 an der Grundplatte 2 angebunden. Die Stromschienen 3 sind durch vier Federelemente 6 an der Grundplatte 2 angebunden.

Die Federelemente 6 sind jeweils über einen Rahmen 7 mit den Stromschienen 3 verbunden. Die Stromschienen 3 sind in die Rahmen 7 eingefasst. Die Federelemente 6, die Rahmen 7 und die Grundplatte 2 sind materialeinheitlich und einstückig ausgebildet. Die Federelemente 6, die Rahmen 7 und die Grundplatte 2 sind spritzgusstechnisch an die Stromschienen 3 angeformt. Die Grundplatte 2 ist als Kunststoffplatte aus Polyamid ausgestaltet Die Grundplatte 2 weist eine Dicke von 2,0 - 3,0 mm auf.

Die Grundplatte 2 weist Ausnehmungen 8 auf, in denen die Stromschienen 3 aufgenommen sind. Die Stromschienen 3 sind in den Ausnehmungen 8 aufgenommen und von den Rändern 9 der Ausnehmungen 8 beabstandet. Die Ausnehmungen 8 sind im Wesentlichen rechteckig ausgestaltet.

Die Stromschienen 3 und eine auf der Grundplatte 2 aufliegende Lage 10 stehen durch die Kontaktelemente 5 miteinander in elektrischem Kontakt. Die Lage ist als flexibler Flachleiter mit Leiterbahnen 4 ausgestaltet. Die Lage 10 steht über den Anschluss 11 mit einer nicht gezeigten Oberwachungselektronik oder einem Batterie-Management-System in Verbindung

Hinsichtlich weiterer vorteilhafter Ausgestaltungen und Weiterbildungen der erfindungsgemäßen Lehre wird einerseits auf den allgemeinen Teil der Beschreibung und andererseits auf die beigefügten Patentansprüche verwiesen.

## Patentansprüche

1. Busbarplatte (1) für eine Batterie mit einzelnen Zellen, umfassend eine Grundplatte (2) und Stromschienen (3) zur Kontaktierung von Polanschlüssen der Zellen, wobei auf der Grundplatte (2) Leiterbahnen (4) verlaufen, die über Kontaktelemente (5) mit den Stromschienen (3) elektrisch leitend verbunden sind,
**dadurch gekennzeichnet, dass** die Kontaktelemente (5) an den Stromschienen (3) relativ zur Grundplatte (2) flexibel beweglich angebunden sind.

2. Busbarplatte nach Anspruch 1, **dadurch gekennzeichnet, dass** die Stromschienen (3) flexibel beweglich an der Grundplatte (2) angebunden sind.

3. Busbarplatte nach Anspruch 1 oder 2, **dadurch gekennzeichnet, dass** die Stromschienen (3) federnd und/ oder elastisch beweglich an der Grundplatte (2) angebunden sind.

4. Busbarplatte nach einem der Ansprüche 1 bis 3, **dadurch gekennzeichnet, dass** die Stromschienen (3) durch Federelemente (6) an der Grundplatte (2) angebunden sind.

5. Busbarplatte nach einem der Ansprüche 1 bis 4, **dadurch gekennzeichnet, dass** die Stromschienen (3) durch ein Elastomer an der Grundplatte (2) angebunden sind.

6. Busbarplatte nach einem der Ansprüche 1 bis 5, **dadurch gekennzeichnet, dass** die Stromschienen (3) durch einen Schaum an der Grundplatte (2) angebunden sind.

7. Busbarplatte nach einem der Ansprüche 1 bis 6, **dadurch gekennzeichnet, dass** die Grundplatte (2) Ausnehmungen (8) aufweist, in denen die Stromschienen (3) aufgenommen sind.

8. Busbarplatte nach Anspruch 7, **dadurch gekennzeichnet, dass** die Stromschienen (3) in den Ausnehmungen (8) aufgenommen sind und von den Rändern (9) der Ausnehmungen (8) beabstandet sind.

9. Busbarplatte nach einem der Ansprüche 1 bis 8, **dadurch gekennzeichnet, dass** die Stromschienen (3) in Rahmen (7) eingefasst sind.

10. Busbarplatte nach einem der Ansprüche 1 bis 9, **dadurch gekennzeichnet, dass** die Grundplatte (2) als Kunststoffplatte ausgestaltet ist.

11. Busbarplatte nach einem der Ansprüche 1 bis 10, **dadurch gekennzeichnet, dass** die Stromschienen (3) und eine auf der Grundplatte (2) aufliegende Lage (10) durch die Kontaktelemente (5) miteinander in elektrischem Kontakt stehen.

12. Busbarplatte nach Anspruch 11, **dadurch gekennzeichnet, dass** die Lage (10) als flexibler Flachleiter mit Leiterbahnen (4) ausgestaltet ist.
